# EUROPÄISCHE PATENTSCHRIFT

(11) **EP 2 398 658 B1**
(45) Veröffentlichungstag und Bekanntmachung des Hinweises auf die Patenterteilung: **09.01.2013**
(21) Anmeldenummer: 10700842.7
(22) Anmeldetag: 11.01.2010
(51) Int. Cl.: B60C 23/04, H01L 41/113

(54) **PIEZOELEKTRISCHER GENERATOR**
PIEZOELECTRIC GENERATOR
GÉNÉRATEUR PIÉZOÉLECTRIQUE

(30) Priorität: 20.02.2009 DE 102009001031
(43) Veröffentlichungstag der Anmeldung: 28.12.2011
(73) Patentinhaber: Robert Bosch GmbH, 70442 Stuttgart (DE)
(72) Erfinder: LAERMER, Franz, 71263 Weil der Stadt (DE); PANNEK, Thorsten, 70176 Stuttgart (DE); REICHENBACH, Ralf, 73732 Esslingen (DE); KECK, Marian, 71229 Leonberg (DE)
(86) Internationale Anmeldenummer: PCT/EP2010/050220
(87) Internationale Veröffentlichungsnummer: WO 2010/094520

(56) Entgegenhaltungen:
- EP-A1- 2 113 953
- DE-A1-102007 006 994

## Beschreibung

Die vorliegende Erfindung betrifft einen piezoelektrischen Generator, insbesondere zum Einsatz in einem Fahrzeugreifenkontrollsystem.

### Stand der Technik

Drahtlose elektronische Geräte finden eine immer weitere Verbreitung. Problematisch ist hierbei jedoch die Energieversorgung. Batterie oder Akkumulatoren sind meist groß und schwer und müssen ersetzt oder nachgeladen werden.

Bei Anwendungen mit niedrigem Stromverbrauch kommen piezoelektrische Generatoren, welche die Umgebungsenergie, beispielsweise in Form von Schwingungen, durch mechanisch-elektrische Wandlung in elektrische Energie umwandeln, als Energiequellen in Betracht.

Die DE 10 2007 006 994 A1 beschreibt einen piezoelektrischen Generator, in dem ein Masseelement und eine Federeinrichtung, welche ein piezoelektrisches Element aufweist, ein schwingfähiges System bilden. Zum Schutz vor Überlastung durch sehr große Beschleunigungen besitzt dieser piezoelektrische Generator Anschläge, welche die Auslenkung des Systems begrenzen. Bei Auftreffen auf einen Anschlag können jedoch hochfrequente Schwingungen auftreten, welche die Lebensdauer des piezoelektrischen Generators beeinträchtigen können.

Aus der nachveröffentlichten EP 2 113 953 A1 ist eine Vorrichtung zur Erzeugung elektrischer Energie unter Ausnutzung von Zentrifugalkräften bekannt, bei dem eine Masseeinrichtung mit einem Trageelement verbunden ist, wobei mit dem Trageelement ein piezoelektrisches Element derart verbunden ist, dass es bei der Einwirkung von Zentrifugalkraft auf die Masse zusammengepresst wird. Dämpfungselemente aus einem elastischen Siliziummaterial sind beiderseitig des Trageelementes angeordnet.

Gegenstand der vorliegenden Erfindung ist ein piezoelektrischer Generator, welcher ein piezoelektrisches Element, ein Federelement, ein Massenelement und mindestens einen Anschlag aufweist, wobei das piezoelektrische Element, das Federelement und das Massenelement ein schwingungsfähiges, insbesondere biegeschwingungsfähiges, System bilden, wobei der Anschlag die Schwingung des schwingungsfähigen Systems zumindest einseitig begrenzt. Erfindungsgemäß ist dabei der Anschlag aus einem duktilen Material ausgebildet oder weist eine Beschichtung aus einem duktilen Material auf.

Durch eine Verformung des Materials kann dem schwingungsfähigen System Energie entzogen werden und hochfrequente Schwingungen können verringert oder vermieden werden. Dies hat wiederum den Vorteil, dass die Zuverlässigkeit des piezoelektrischen Generators erhöht und die Lebensdauer des piezoelektrischen Generators verlängert werden kann. Im Gegensatz zu einem erfindungsgemäßen Anschlag aus einem duktilen Material, würde ein nicht-duktiler Anschlag, beispielsweise aus einem harten Stahl, den Impuls direkt und ungedämpft wieder ins System zurückgeben und dabei höherfrequentere, schädlichere Schwingungsformen anregen.

Als duktile Material kann ein kubisch flächenzentriert kristallisierendes Metall oder eine kubisch flächenzentriert kristallisierende Metalllegierung eingesetzt werden. Beispielsweise kann das duktile Material ausgewählt werden aus der Gruppe bestehend aus Aluminium, Kupfer, Eisen, Gold, Silber, Blei, Nickel, Platin und Legierungen davon. Aus Umweltgesichtspunkten ist es gegebenenfalls von Vorteil Blei nicht als duktiles Material zu verwenden. Deshalb wird das duktile Material im Rahmen einer Ausführungsform der vorliegenden Erfindung ausgewählt aus der Gruppe bestehend aus Aluminium, Kupfer, Eisen, Gold, Silber, Nickel, Platin und Legierungen davon.

Das duktile Material kann im Rahmen der vorliegenden Erfindung auch ein Kunststoff, beispielsweise ein zäher und widerstandsfähiger Kunststoff, sein. Um die Widerstandsfähigkeit eines Kunststoffes zu erhöhen können dem Kunststoff Fasern, beispielsweise Glasfasern, zugesetzt werden. Zu Beispiel kann das duktile Material ein Glasfasern-umfassender Kunststoff, beispielsweise ein glasfasergefülltes Polyamid, sein. Kunststoffanschlägen können beispielsweise mittels eines, insbesondere 2-Komponenten, Spritzgussverfahrens, beispielsweise zusammen mit einem Gehäuse oder anderen Bauteil, ausgebildet sein.

Im Rahmen einer Ausführungsform der Erfindung weist der piezoelektrische Generator zwei oder mehr Anschläge auf. Insbesondere begrenzen die Anschläge dabei die Schwingung des schwingfähigen Systems beidseitig. Hierfür sind die Anschläge vorzugsweise auf beiden Auslenkungsseiten der Schwingung angeordnet. Beispielswiese können auf jeder Auslenkungsseite ein bis fünf Anschläge angeordnet sein. Insbesondere kann der piezoelektrische Generator eine gradzahlige Zahl an Anschlägen aufweisen, wobei jeweils die eine Hälfte der Anschläge die Schwingung des schwingfähigen Systems auf der einen Auslenkungsseite und die andere Hälfte der Anschläge die Schwingung des schwingfähigen Systems auf der anderen Auslenkungsseite begrenzen. Vorzugsweise sind die Anschläge im Rahmen der vorliegenden Erfindung derart angeordnet, dass die Anschläge das schwingungsfähige System vor Überlastung durch große Beschleunigungen schützen beziehungsweise die Schwingungen des schwingungsfähigen Systems auf ein Niveau begrenzen, auf dem das schwingungsfähige System nicht über seine mechanische Festigkeit hinaus beansprucht wird.

Im Rahmen einer weiteren Ausführungsform der Erfindung weist der piezoelektrische Generator mindestens eine Wirbelstrombremse auf. Vorzugsweise bremst die Wirbelstrombremse die Schwingung des schwingungsfähigen Systems zumindest einseitig ab. Auf diese Weise kann die Wirbelstrombremse dem System im Fall einer Überlastung zusätzlich zu den energieabsorbierenden Anschlägen Energie entziehen.

Als Wirbelstrombremse eignet sich beispielsweise ein Permanentmagnet. Vorzugsweise ist die Wirbelstrombremsen in unmittelbarer Nähe zumindest eines Anschlags angeordnet. Durch die Schwingungen des schwingungsfähigen Systems und die Wirbelstrombremse kann eine Spannung und damit Wirbelströme in dem schwingungsfähigen System induziert werden, wobei ein dem Magnetfeld der Wirbelstrombremse entgegengesetztes Magnetfeld erzeugt wird. Bei einer Schwingung mit geringer Auslenkung, beispielsweise im Normalbetrieb des Generators, ist das erzeugte Magnetfeld vorzugsweise gering und hat keinen oder nur einen sehr geringen Einfluss auf die Schwingung des schwingungsfähigen Systems. In unmittelbarer Nähe der Wirbelstrombremse ist das erzeugte Magnetfeld vorzugsweise jedoch so groß, dass die Schwingung des schwingungsfähigen Systems abgebremst wird. Vor oder bei der Wirbelstrombremse beziehungsweise dem Anschlag ist die Geschwindigkeit des ausgelenkten Bereichs des schwingungsfähigen Systems vorzugsweise stark abgebremst oder gleich Null. Da Erregungsschwingungen mit großen Amplituden hohe Geschwindigkeiten und diese wiederum starke Wirbelströme verursachen, werden diese vorteilhafterweise besonders stark abgebremst.

Im Rahmen einer weiteren Ausführungsform der Erfindung ist das Federelement und/oder das Massenelement aus einem Metall oder einer Metalllegierung mit einer hohen elektrischen Leitfähigkeit ausgebildet. Dies hat den Vorteil, dass induzierten Wirbelströme aufgrund der hohen elektrischen Leitfähigkeit höher sind und damit die Bremswirkung maximiert wird. Unter einem Metall oder einer Metalllegierung mit einer hohen elektrischen Leitfähigkeit kann im Rahmen der vorliegenden Erfindung insbesondere ein Metall oder einer Metalllegierung mit einer elektrischen Leitfähigkeit von ≥ 15 · 10⁶ S/m bei 300 K, beispielsweise ein Metall oder eine Metalllegierung ausgewählt aus der Gruppe bestehend aus Silber, Kupfer, Gold, Aluminium und Legierungen davon, verstanden werden.

Im Rahmen einer weiteren Ausführungsform der Erfindung weist der piezoelektrische Generator zwei oder mehr Wirbelstrombremsen auf. Vorzugsweise bremsen die Wirbelstrombremsen die Schwingung des schwingfähigen Systems beidseitig ab. Hierfür können die Wirbelstrombremsen auf beiden Auslenkungsseiten der Schwingung angeordnet sein. Vorzugsweise weist der piezoelektrische Generator eine gradzahlige Zahl an Wirbelstrombremsen auf, wobei die eine Hälfte der Wirbelstrombremsen die Schwingung des schwingfähigen Systems auf der einen Auslenkungsseite und die andere Hälfte der Wirbelstrombremsen die Schwingungen des schwingfähigen Systems auf der anderen Auslenkungsseite abbremst. Die auf den beiden Auslenkungsseiten der Schwingung angeordneten Wirbelstrombremsen können dabei insbesondere symmetrisch zueinander angeordnet sein. Vorzugsweise sind die Wirbelstrombremsen derart auf den beiden Auslenkungsseiten der Schwingung angeordnet sind, dass sich deren Magnetfelder in der Ebene des schwingungsfähigen Systems aufheben. Dies hat den Vorteil, dass bei Schwingungen im Kleinsignalbereich, das heißt innerhalb dieser "neutralen Zone", keine oder nur eine geringe Bremswirkung durch Wirbelströme verursacht wird, wobei größere oder gar durch Überlast verursachte Schwingungen die neutrale Zone verlassen und eine starke Bremswirkung durch Wirbelströme erfahren.

Im Rahmen der vorliegenden Erfindung ist das piezoelektrische Element vorzugsweise bei der Schwingung des schwingungsfähigen Systems elastisch verformbar. Das piezoelektrische Element, das Federelement und das Massenelement können im Wesentlichen flächig ausgebildet sein. Dabei kann unter einer "flächigen Ausbildung" ein flacher dreidimensionaler Körper verstanden werden. Insbesondere kann das piezoelektrische Element streifenförmig ausgebildet sein und/oder das Federelement kann eine Blattfeder sein. Vorzugsweise weist das schwingungsfähige System eine Sandwichstruktur auf beziehungsweise sind das piezoelektrische Element, das Federelement und das Massenelement sandwichartig ausgebildet und angeordnet. Beispielsweise ist das Federelement dabei zwischen dem piezoelektrischen Element und dem Massenelement angeordnet.

Im Rahmen einer weiteren Ausführungsform der Erfindung der piezoelektrische Generator ein Gehäuse aufweist. Das schwingungsfähige System ist vorzugsweise innerhalb des Gehäuses schwingungsfähig angeordnet. Das schwingungsfähige System, die Anschläge und/oder die Wirbelstrombremse/n können an dem Gehäuse angeordnet sein.

Im Rahmen einer weiteren Ausführungsform der Erfindung weist der piezoelektrische Generator einen Energiespeicher zur Speicherung der von dem piezoelektrischen Element erzeugten elektrischen Energie auf.

Ein weiterer Gegenstand der vorliegenden Erfindung ist eine elektronische Vorrichtung, welche einen erfindungsgemäßen piezoelektrischen Generator umfasst. Die elektronische Vorrichtung kann beispielsweise eine Stromnetzanschluss-freie und/oder portable elektronische Vorrichtung sein. Insbesondere kann der erfindungsgemäße piezoelektrische Generator die einzige Energiequelle der elektronischen Vorrichtung sein. Die elektronische Vorrichtung kann weiterhin einen oder mehrere Sensoren, beispielsweise einen Drucksensor und/oder einen Temperatursensor und/oder einen Beschleunigungssensor umfassen. Insbesondere kann die elektronische Vorrichtung ein Fahrzeugreifenkontrollsystem sein.

Ein weiterer Gegenstand der vorliegenden Erfindung ist die Verwendung eines erfindungsgemäßen piezoelektrischen Generators in elektronischen Vorrichtung, beispielsweise einer Stromnetzanschluss-freien elektronischenvorrichung, insbesondere einem Fahrzeugreifenkontrollsystem.

### Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen:

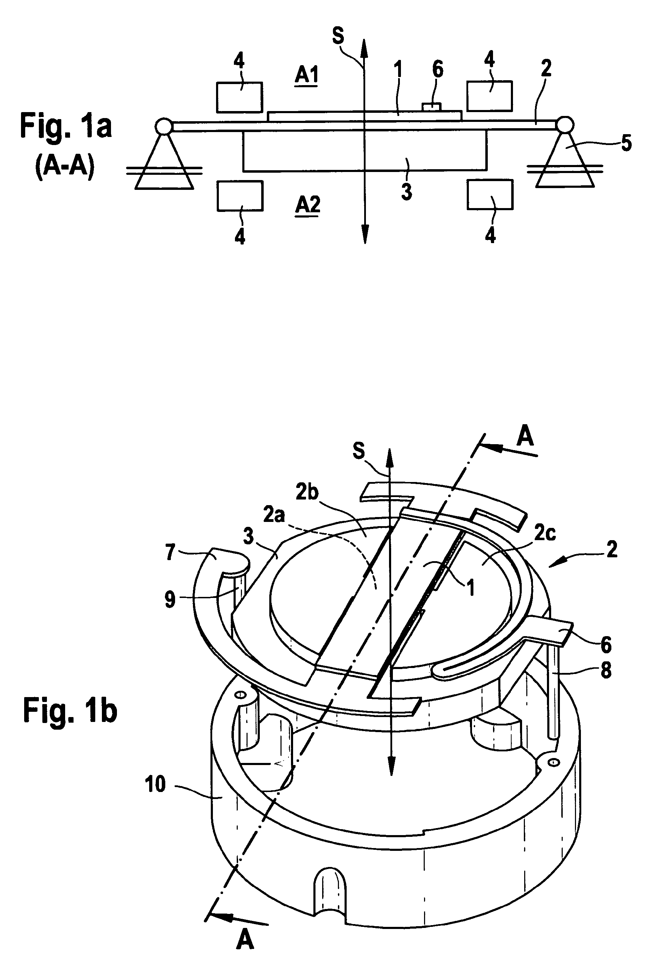

- Fig. 1a: einen schematischen Querschnitt durch eine erste Ausführungsform eines erfindungsgemäßen piezoelektrischen Generators entlang der Linie A-A;
- Fig. 1 b: eine schematische, perspektivische Ansicht der in Fig. 1 a gezeigten ersten Ausführungsform (Anschläge nicht dargestellt);
- Fig. 2a: einen schematischen Querschnitt durch eine zweite Ausführungsform eines erfindungsgemäßen piezoelektrischen Generators entlang der Linie A-A; und
- Fig. 2b: eine schematische, perspektivische Ansicht der in Fig. 2a gezeigten zweiten Ausführungsform (Anschläge nicht dargestellt).

Figur 1a zeigt eine erste Ausführungsform eines erfindungsgemäßen piezoelektrischen Generators, welcher ein piezoelektrisches Element **1**, ein Federelement **2**, ein Massenelement **3** und vier Anschläge **4** aufweist. Figur 1 a veranschaulicht, dass das piezoelektrische Element **1**, das Federelement **2** und das Massenelement **3** ein schwingungsfähiges System bilden. Die mit dem Bezugszeichen **5** gekennzeichneten Symbole symbolisieren, dass dieses schwingungsfähig gelagert ist.

Figur 1a illustriert, dass das schwingungsfähige System eine Sandwichstruktur aufweist, wobei das piezoelektrische Element **1**, das Federelement **2** und das Massenelement **3** im Wesentlichen flächig ausgebildet sind und das Federelement **2** zwischen dem piezoelektrischen Element **1** und dem Massenelement **3** angeordnet ist. Dabei ist das piezoelektrische Element **1** derart streifenförmig ausgebildet und angeordnet, dass dieses bei der Schwingung des schwingungsfähigen Systems elastisch verformbar ist. Figur 1 a zeigt weiterhin, dass das piezoelektrische Element **1** über einen ersten elektrischen Kontakt **6** und über das Federelement **2** elektrisch kontaktierbar beziehungsweise kontaktiert ist.

Figur 1 a zeigt, dass die Anschläge **4** die Schwingung des schwingfähigen Systems beidseitig begrenzen. Dabei sind die Anschläge **4** auf beiden Auslenkungsseiten **A1**, **A2** der Schwingung symmetrisch zueinander und in Schwingungsrichtung **S** beabstandet zum schwingungsfähigen System angeordnet.

Figur 1b zeigt eine schematische, perspektivische Ansicht der in Fig. 1a gezeigten ersten Ausführungsform. Die Anschläge **4** sind in Figur 1b nicht dargestellt. Figur 1b illustriert, dass der piezoelektrische Generator ein Gehäuse **10** aufweist, in dem das schwingungsfähige System schwingungsfähig angeordnet und befestigt ist. Das Federelement **2** ist im Wesentlichen in Form einer Blattfeder ausgebildet.

Im Rahmen der in Figur 1b gezeigten Ausführungsform umfasst das Federelement **2** einen elastische Federbereich **2a** (verdeckt durch das piezoelektrische Element **1**) und zwei Massenelementkontaktbereiche **2b**, **2c**. Das piezoelektrische Element liegt an dem Federbereich **2a** des Federelements **2** an. Figur 1b veranschaulicht, dass der gezeigte piezoelektrische Generator zur elektrischen Kontaktierung des piezoelektrischen Elements **1** zwei elektrische Kontakte **6, 7** aufweist. In Figur 1b sind diese in der Ebene, das schwingungsfähige System umlaufend angeordnet. Der erste elektrische Kontakt **6** liegt auf dem piezoelektrischen Element **1** auf. Der zweite elektrische Kontakt **7** kontaktiert das piezoelektrische Element **1** über den elastischen Federbereich **2a**. Figur 1b zeigt weiterhin, dass der erste **6** und zweite **7** elektrische Kontakt jeweils über ein durch das Gehäuse **10** geführtes erstes **8** und zweites **9** Kontaktelement kontaktierbar beziehungsweise kontaktiert ist.

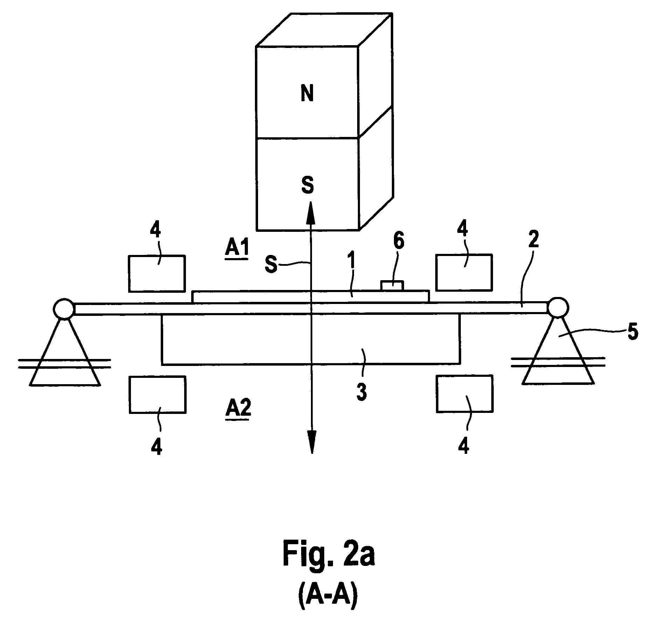

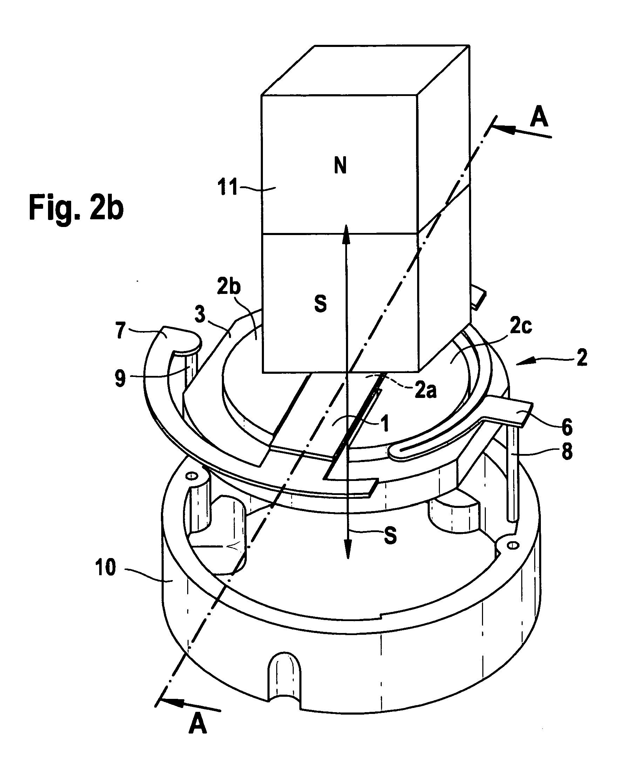

Die Figuren 2a und 2b zeigen eine zweite Ausführungsform eines erfindungsgemäßen piezoelektrischen Generators. Die zweite Ausführungsform unterscheidet sich dadurch von der ersten, in den Figuren 1a und 1b gezeigten Ausführungsform, dass der erfindungsgemäße piezoelektrische Generator weiterhin eine Wirbelstrombremse **11** aufweist. Im Rahmen der zweiten Ausführungsform ist die Wirbelstrombremse **11** in Schwingungsrichtung **S** beabstandet zum schwingungsfähigen System angeordnet und bremst die Wirbelstrombremse **11** die Schwingung des schwingungsfähigen Systems einseitig ab. Das Magnetfeld der Wirbelstrombremse **11** durchsetzt dabei das schwingungsfähige System in Schwingungsrichtung **S** beziehungsweise senkrecht zur Hauptfläche des schwingungsfähigen Systems. Eine maximale Bremswirkung kann dadurch erzielt werden, dass der Bereich mit der maximalen Schwingung des schwingungsfähigen Systems unter- beziehungsweise oberhalb des Erregerpols der Wirbelstrombremse angeordnet ist. Vorteilhafterweise sind das Federelement **2** und das Massenelement **3** derart ausgestaltet, dass sich die Wirbelströme möglichst großräumig und ungestört von Nuten, Einschnitten und ähnlichem ausbilden können.

## Patentansprüche

1. Piezoelektrischer Generator, aufweisend
- ein piezoelektrisches Element (1),
- ein Federelement (2),
- ein Massenelement (3) und
- mindestens einen Anschlag (4),
wobei das piezoelektrische Element (1), das Federelement (2) und das Massenelement (3) ein schwingungsfähiges System bilden, wobei der Anschlag (4) die Schwingung des schwingungsfähigen Systems zumindest einseitig begrenzt, wobei der Anschlag (4) aus einem duktilen Material ausgebildet ist oder eine Beschichtung aus dem duktilen Material aufweist, wobei das duktile Material ein kubisch flächenzentriert kristallisierendes Metall, eine kubisch flächenzentriert kristallisierende Metalllegierung oder ein Kunststoff, dem Fasern zugesetzt sind, ist.

2. Piezoelektrischer Generator nach Anspruch 1, **dadurch gekennzeichnet, dass** das kubisch flächenzentriert kristallisierende Metall oder die kubisch flächenzentriert kristallisierende Metalllegierung ausgewählt ist aus der Gruppe bestehend aus Aluminium, Kupfer, Eisen, Gold, Silber, Blei, Nickel, Platin und Legierungen davon.

3. Piezoelektrischer Generator nach einem der vorhergehenden Ansprüche, **dadurch gekennzeichnet, dass** der piezoelektrische Generator zwei oder mehr Anschläge (4) aufweist, wobei die Anschläge (4) die Schwingung des schwingfähigen Systems beidseitig begrenzen.

4. Piezoelektrischer Generator nach einem der vorhergehenden Ansprüche, **dadurch gekennzeichnet, dass** der piezoelektrischer Generator mindestens eine Wirbelstrombremse (11) aufweist, wobei die Wirbelstrombremse (11) die Schwingung des schwingungsfähigen Systems zumindest einseitig abbremst.

5. Piezoelektrischer Generator nach Anspruch 4, **dadurch gekennzeichnet, dass** der piezoelektrische Generator zwei oder mehr Wirbelstrombremsen (11) aufweist, wobei die Wirbelstrombremsen (11) die Schwingung des schwingfähigen Systems beidseitig abbremsen.

6. Piezoelektrischer Generator nach Anspruch 4 oder 5, **dadurch gekennzeichnet, dass** der piezoelektrische Generator eine gradzahlige Zahl an Wirbelstrombremsen (11) aufweist, wobei die eine Hälfte der Wirbelstrombremsen (11) die Schwingung des schwingfähigen Systems auf der einen Auslenkungsseite (A1) und die andere Hälfte der Wirbelstrombremsen (11) die Schwingungen des schwingfähigen Systems auf der anderen Auslenkungsseite (A2) abbremst.

7. Piezoelektrischer Generator nach einem der Ansprüche 4 bis 6, **dadurch gekennzeichnet, dass** die Wirbelstrombremsen (11) derart auf den beiden Auslenkungsseiten der Schwingung angeordnet sind, dass sich deren Magnetfelder in der Ebene des schwingungsfähigen Systems aufheben.

8. Piezoelektrischer Generator nach einem der Ansprüche 4 bis 7, **dadurch gekennzeichnet, dass** die Wirbelstrombremse/n (11) jeweils in unmittelbarer Nähe zumindest eines Anschlags (4) angeordnet sind.

9. Piezoelektrischer Generator nach einem der Ansprüche 4 bis 8, **dadurch gekennzeichnet, dass** die Wirbelstrombremse (11) ein Permanentmagnet ist.

10. Piezoelektrischer Generator nach einem der Ansprüche 4-9, **dadurch gekennzeichnet, dass** der piezoelektrische Generator ein Gehäuse (10) aufweist, wobei das schwingungsfähige System innerhalb des Gehäuses (10) und an dem Gehäuse (10) schwingungsfähig angeordnet ist und wobei der oder die Anschläge (4) und die Wirbelstrombremse/n (11) an dem Gehäuse (10) angeordnet sind.

11. Piezoelektrischer Generator nach einem der vorhergehenden Ansprüche, **dadurch gekennzeichnet, dass** das Federelement (2) und/oder das Massenelement (3) aus einem Metall oder einer Metalllegierung mit einer hohen elektrischen Leitfähigkeit ausgebildet ist.

12. Elektronische Vorrichtung, umfassend einen piezoelektrischen Generator nach einem der Ansprüche 1 bis 11.

13. Elektronische Vorrichtung nach Anspruch 12, **dadurch gekennzeichnet, dass** die elektronische Vorrichtung ein Fahrzeugreifenkontrollsystem ist.

## Claims

1. Piezoelectric generator, having
- a piezoelectric element (1),
- a spring element (2),
- a mass element (3) and
- at least one stop (4),
the piezoelectric element (1), the spring element (2) and the mass element (3) forming an oscillatory system, the stop (4) limiting the oscillation of the oscillatory system, at least on one side, the stop (4) being formed from a ductile material or having a coating of a ductile material and the ductile material being a face-centred cubic crystallizing metal, a face-centred cubic crystallizing metal alloy or a plastic to which fibres have been added.

2. Piezoelectric generator according to Claim 1, **characterized in that** the face-centred cubic crystallizing metal or the face-centred cubic crystallizing metal alloy is selected from the group consisting of aluminium, copper, iron, gold, silver, lead, nickel, platinum and alloys thereof.

3. Piezoelectric generator according to one of the preceding claims, **characterized in that** the piezoelectric generator has two or more stops (4), the stops (4) limiting the oscillation of the oscillatory system on both sides.

4. Piezoelectric generator according to one of the preceding claims, **characterized in that** the piezoelectric generator has at least one eddy current brake (11), the eddy current brake (11) slowing down the oscillation of the oscillatory system, at least on one side.

5. Piezoelectric generator according to Claim 4, **characterized in that** the piezoelectric generator has two or more eddy current brakes (11), the eddy current brakes (11) slowing down the oscillation of the oscillatory system on both sides.

6. Piezoelectric generator according to Claim 4 or 5, **characterized in that** the piezoelectric generator has an even number of eddy current brakes (11), one half of the eddy current brakes (11) slowing down the oscillation of the oscillatory system on one deflecting side (A1) and the other half of the eddy current brakes (11) slowing down the oscillations of the oscillatory system on the other deflecting side (A2).

7. Piezoelectric generator according to one of Claims 4 to 6, **characterized in that** the eddy current brakes (11) are arranged on the two deflecting sides of the oscillation in such a way that their magnetic fields cancel one another out in the plane of the oscillatory system.

8. Piezoelectric generator according to one of Claims 4 to 7, **characterized in that** the eddy current brake(s) (11) are respectively arranged in the direct vicinity of at least one stop (4).

9. Piezoelectric generator according to one of Claims 4 to 8, **characterized in that** the eddy current brake (11) is a permanent magnet.

10. Piezoelectric generator according to one of Claims 4-9, **characterized in that** the piezoelectric generator has a housing (10), the oscillatory system being arranged such that it can oscillate within the housing (10) and on the housing (10) and the stop or stops (4) and the eddy current brake(s) (11) being arranged on the housing (10).

11. Piezoelectric generator according to one of the preceding claims, **characterized in that** the spring element (2) and/or the mass element (3) is/are formed from a metal or a metal alloy with a high electrical conductivity.

12. Electronic device, comprising a piezoelectric generator according to one of Claims 1 to 11.

13. Electronic device according to Claim 12, **characterized in that** the electronic device is a vehicle tyre monitoring system.

## Revendications

1. Générateur piézoélectrique présentant :
- un élément piézoélectrique (1),
- un élément élastique (2),
- un élément de masse (3) et
- au moins une butée (4),
l'élément piézoélectrique (1), l'élément élastique (2) et l'élément de masse (3) formant un système apte à osciller, la butée (4) limitant au moins sur un côté les oscillations du système oscillant, la butée (4) étant formée d'un matériau ductile ou présentant un revêtement en matériau ductile, le matériau ductile étant un métal à cristallisation cubique face centrée, un alliage de métaux à cristallisation cubique face centrée ou une matière synthétique à laquelle des fibres sont ajoutées.

2. Générateur piézoélectrique selon la revendication 1, **caractérisé en ce que** le métal à cristallisation cubique à face centrée ou l'alliage de métaux à cristallisation cubique à face centrée sont sélectionnés dans l'ensemble constitué de l'aluminium, du cuivre, du fer, de l'or, de l'argent, du plomb, du nickel, du platine et de leurs alliages.

3. Générateur piézoélectrique selon l'une des revendications précédentes, **caractérisé en ce que** le générateur piézoélectrique présente deux ou plusieurs butées (4), les butées (4) délimitant de deux côtés les oscillations du système oscillant.

4. Générateur piézoélectrique selon l'une des revendications précédentes, **caractérisé en ce que** le générateur piézoélectrique présente au moins un frein (11) à courants de Foucault, le frein (11) à courants de Foucault freinant sur au moins un côté les oscillations du système oscillant.

5. Générateur piézoélectrique selon la revendication 4, **caractérisé en ce que** le générateur piézoélectrique présente deux ou plusieurs freins (11) à courants de Foucault, les freins (11) à courants de Foucault freinant des deux côtés les oscillations du système oscillant.

6. Générateur piézoélectrique selon les revendications 4 ou 5, **caractérisé en ce que** le générateur piézoélectrique présente un nombre pair de freins (11) à courants de Foucault, une moitié des freins (11) à courants de Foucault freinant les oscillations du système oscillant sur un côté (A1) des déviations et l'autre moitié des freins (11) à courants de Foucault freinant les oscillations du système oscillant sur l'autre côté (A2) des déviations.

7. Générateur piézoélectrique selon l'une des revendications 4 à 6, **caractérisé en ce que** les freins (11) à courants de Foucault sont disposés sur les deux côtés de déviation des oscillations de telle sorte que leurs champs magnétiques se suppriment dans le plan du système oscillant.

8. Générateur piézoélectrique selon l'une des revendications 4 à 7, **caractérisé en ce que** le ou les freins (11) à courants de Foucault sont tous disposés à proximité immédiate d'au moins une butée (4).

9. Générateur piézoélectrique selon l'une des revendications 4 à 8, **caractérisé en ce que** le frein (11) à courants de Foucault est un aimant permanent.

10. Générateur piézoélectrique selon l'une des revendications 4 à 9, **caractérisé en ce que** le générateur piézoélectrique présente un boîtier (10), le système oscillant étant disposé à l'intérieur du boîtier (10) et de manière à pouvoir osciller sur le boîtier (10), la ou les butées (4) et le ou les freins (11) à courants de Foucault étant disposés sur le boîtier (10).

11. Générateur piézoélectrique selon l'une des revendications précédentes, **caractérisé en ce que** l'élément élastique (2) et/ou l'élément de masse (3) sont formés d'un métal ou d'un alliage de métaux à haute conductivité électrique.

12. Dispositif électronique comprenant un générateur piézoélectrique selon l'une des revendications 1 à 11.

13. Dispositif électronique selon la revendication 12, **caractérisé en ce que** le dispositif électronique est un système de contrôle des bandages de roue d'un véhicule.
